## Europäisches Patentamt
## European Patent Office
## Office européen des brevets

(19)

(11) Veröffentlichungsnummer : **0 234 526 B1**

(12) # EUROPÄISCHE PATENTSCHRIFT

(45) Veröffentlichungstag der Patentschrift :
05.06.91 Patentblatt 91/23

(51) Int. Cl.⁵ : **G01R 33/56**

(21) Anmeldenummer : 87102450.1

(22) Anmeldetag : 20.02.87

(54) Verfahren zum Bestimmen fliessenden Materials mittels NMR-Tomographie.

(30) Priorität : 25.02.86 DE 3605990

(43) Veröffentlichungstag der Anmeldung :
02.09.87 Patentblatt 87/36

(45) Bekanntmachung des Hinweises auf die
Patenterteilung :
05.06.91 Patentblatt 91/23

(84) Benannte Vertragsstaaten :
CH DE FR GB LI

(56) Entgegenhaltungen :
EP-A- 0 117 134
INVESTIGATIVE RADIOLOGY, Band 17, Nr. 6,
1982, Seiten 554-560, J.B. Lippincott Co.; L.
KAUFMAN et al.: "Evaluation of NMR imaging
for detection and quantification of obstructions in vessels"

(56) Entgegenhaltungen :
SCIENCE, Band 221, August 1983, Seiten
654-656; J.R. SINGER et al.: "Nuclaer magnetic resonance blood flow measurements in the
human brain"
MAGNETIC RESONANCE IN MEDICINE, Band
1, Nr. 2, Juni 1984, Seiten 151-152, Nr. 71, New
York, US; D.A. FEINBERG: "Determination of
velocity and pulse pressure in pulsatile blood
using a new spin-echo pulse sequence for
NMR imaging"

(73) Patentinhaber : Spectrospin AG
Industriestrasse 26
CH-8117 Zürich-Fällanden (CH)

(72) Erfinder : Hennig, Jürgen, Dr.
Johann-von-Weerth-Strasse 12
W-7800 Freiburg (DE)
Erfinder : Müri, Marcel
Im Lindengut 9
CH-8803 Rüschlikon (CH)

(74) Vertreter : KOHLER SCHMID + PARTNER
Patentanwälte
Ruppmannstrasse 27
W-7000 Stuttgart 80 (DE)

## Beschreibung

Die Erfindung betrifft ein Verfahren zum Bestimmen fließenden Materials innerhalb eines geschlossenen Körpers mittels NMR-Tomographie, bei dem der Körper ausgewählten Magnetfeldern ausgesetzt und die im Bereich einer durch einen Scheibengradienten definierten Querschnittsebene des Körpers vorhandenen Spins selektiv durch Sequenzen von HF-Anregungsimpulsen angeregt werden, deren Abstand kleiner ist als die Spin-Gitter-Relaxationszeit, so daß es im Verlauf der Aufnahmezeit zu einer wenigstens teilweisen Sättigung der Magnetisierung kommt, die ihrerseits eine Verminderung der Intensität der Resonanzsignale zur Folge hat, und bei dem die Resonanzsignale zur Erzeugung eines Bildes der Querschnittsebene des Körpers verarbeitet werden, in dem sich diejenigen Stellen, an denen der Querschnittsebene von außen zugeflossenes und daher weniger gesättigtes Material vorhanden ist, infolge der größeren Intensität der Resonanzsignale von der Umgebung durch eine größere Helligkeit abheben.

Ein solches Verfahren ist aus "Investigative Radiology" 17 (1982), Seiten 554 bis 560, bekannt. Das bekannte Verfahren soll in erster Linie dazu dienen, Gefäßverstopfungen im menschlichen Körper festzustellen. Während gesunde Gefäße wegen des darin herrschenden Blutstromes an ihrer hohen Signalintensität erkennbar sind, führen Verstopfungen zu einer Verminderung der Fließgeschwindigkeit und/oder zu einer Gefäßeinengung, die durch entsprechend dunklere Stellen erkennbar sind.

Aus "Science" 221 (1983), Seiten 654 bis 656, ist es ferner bekannt, die Fließgeschwindigkeit von Blut im menschlichen Körper zu bestimmen, indem die Zeit beobachtet wird, die für das Erreichen des Intensitätsmaximums nach der Anregung, also für den vollständigen Austausch des Blutes in dem beobachteten Bereich, benötigt wird.

Die optimale Anwendung eines solchen Verfahrens bei unterschiedlichen Aufgaben erfordert die Optimierung unterschiedlicher Parameter. Wenn es darauf ankommt, sehr enge Gefäße und/oder Gefäße mit geringem Durchsatz festzustellen, kommt es darauf an, einen möglichst großen Kontrast herzustellen. Andererseits kommt es für die Bestimmung der Fließgeschwindigkeit nicht auf einen optimalen Kontrast, sondern auf eine möglichst genaue Bestimmung des ein Gefäß in der Zeiteinheit durchfließenden Flüssigkeitsvolumens an. Darüber hinaus besteht auch das Bedürfnis, die Fließrichtung des Materials festzustellen.

Der Erfindung liegt die Aufgabe zugrunde, das Verfahren der eingangs genannten Art so weiterzubilden, daß die verschiedenen Forderungen wahlweise erfüllt werden können.

Diese Aufgabe wird nach der Erfindung dadurch gelöst, daß auf den Körper zwischen aufeinanderfolgenden HF-Anregungsimpulsen bei Anliegen eines weiteren Scheibengradienten zusätzliche HF-Sättigungsimpulse eingestrahlt werden und durch Wahl des zeitlichen Abstandes zwischen den HF-Anregungsimpulsen und den HF-Sättigungsimpulsen und/oder der durch diese Impulse bewirkten Flipwinkel ein stationärer Zustand mit minimaler Magnetisierung in wenigstens einem der durch die Scheibengradienten bestimmten Bereiche eingestellt wird.

Die Verwendung zusätzlicher HF-Sättigungsimpulse in Verbindung mit einem eigenen Scheibengradienten gestattet es, durch die Wahl der zeitlichen Abstände, der Flipwinkel und auch des Ortes der Anregung unterschiedliche Betriebszustände zu erzeugen, welche für die einzelnen Anwendungszwecke optimiert sind. So ist es insbesondere möglich, die durch die HF-Anregungsimpulse und die durch die HF-Sättigungsimpulse angeregten Bereiche zusammenfallen zu lassen, so daß in dem gesamten, angeregten Bereich eine minimale Magnetisierung erzielt wird, die dazu führt, daß das stationäre Material des Körpers praktisch keinen Signalbeitrag mehr liefert. Damit lassen sich auch sehr geringe Anteile strömenden Materials einwandfrei feststellen.

Es ist aber auch möglich, daß der durch die HF-Sättigungsimpulse angeregte Bereich senkrecht zur Querschnittsebene des Körpers eine größere Ausdehnung hat als der durch die HF-Anregungsimpulse erfaßte Bereich, so daß der durch die HF-Sättigungsimpulse angeregte Bereich den durch die HF-Anregungsimpulse angeregten Bereich einschließt. In diesem Fall wird auch hier wiederum in dem Wirkungsbereich der HF-Anregungsimpulse eine praktisch vollständige Unterdrückung des Signals des stationären Materials und insbesondere von stationärem Körpergewebe erreicht, während in daran angrenzenden Bereichen nur eine Teilsättigung erzielt wird. Eine Einstellung der Dicke dieser Bereiche ermöglicht es, Volumenelemente zu markieren und dadurch die Fließgeschwindigkeit sehr genau zu messen. Wird darüber hinaus dafür Sorge getragen, daß ein Rand des durch die HF-Anregungsimpulse angeregten Bereiches mit einem Rand des durch die HF-Sättigungsimpulse angeregten Bereiches zusammenfällt, läßt sich auch noch die Fließrichtung feststellen, weil von der einen Seite her in den durch die HF-Anregungsimpulse bestimmten Beobachtungsbereich noch völlig ungestörtes Material eintritt, während von der anderen Seite her in diesen Bereich das mittels der HF-Sättigungsimpulse teilweise gesättigte Material eintritt.

Vorzugsweise wird bei Anwendung des erfindungsgemäßen Verfahrens von Sequenzen Gebrauch gemacht, bei denen der während der Dauer der HF-Anregungsimpulse eingeschaltete Scheibengradient nach Ende jedes HF-Anregungsimpulses zur Rephasierung der angeregten Spins umgekehrt wird. Weiterhin wird

2

dabei nach jedem HF-Anregungsimpuls jeweils ein Lesegradient und ggf. ein Phasengradient für die Dauer der Umkehrung des Scheibengradienten eingeschaltet. Danach wird der Lesegradient zur Erzeugung eines Spin-Echo-Signales umgekehrt. Die HF-Sättigungsimpulse werden dabei jeweils zwischen zwei aufeinanderfolgenden HF-Anregungsimpulsen eingestrahlt. Wie bereits erwähnt, liegt auch dann wieder ein Scheibengradient vor, der jedoch nicht mit dem Scheibengradienten übereinzustimmen braucht, der für die Dauer der HF-Anregungsimpulse eingeschaltet ist.

Die Erfindung wird im folgenden anhand der in der Zeichnung dargestellten Ausführungsbeispiele näher beschrieben und erläutert. Die der Beschreibung und der Zeichnung zu entnehmenden Merkmale können bei anderen Ausführungsformen der Erfindung einzeln für sich oder zu mehreren in beliebiger Kombination Anwendung finden. Es zeigen

Fig. 1 das Diagramm einer Anregungs-Sequenz zur Durchführung des erfindungsgemäßen Verfahrens,
Fig. 2 ein Diagramm der bei Verwendung der Anregungs-Sequenz nach Fig. 1 erzielbaren Sättigungszustände,
Fig. 3 einen schematischen Querschnitt durch angeregte Gewebeabschnitte bei Anwendung einer ersten Ausführungsform des erfindungsgemäßen Verfahrens,
Fig. 4 einen schematischen Querschnitt durch angeregte Gewebeabschnitte bei Anwendung einer zweiten Ausführungsform des erfindungsgemäßen Verfahrens,
Fig. 5 ein Zeitdiagramm der bei einer Anregung nach Fig. 4 erzielbaren Signalintensitäten,
Fig. 6 eine Darstellung ähnlich Fig. 4 für eine dritte Ausführungsform des erfindungsgemäßen Verfahrens,
Fig. 7 ein Diagramm des zeitlichen Verlaufs der Signalintensitäten bei einer Anregung nach Fig. 6,
Fig. 8 die Darstellung ähnlich Fig. 4 für eine vierte Ausführungsform des erfindungsgemäßen Verfahrens,
Fig. 9 ein Diagramm des zeitlichen Verlaufs der Signalintensitäten bei einer Anregung nach Fig. 7 und
Fig. 10 das Diagramm einer weiteren Anregungs-Sequenz zur Durchführung des erfindungsgemäßen Verfahrens.

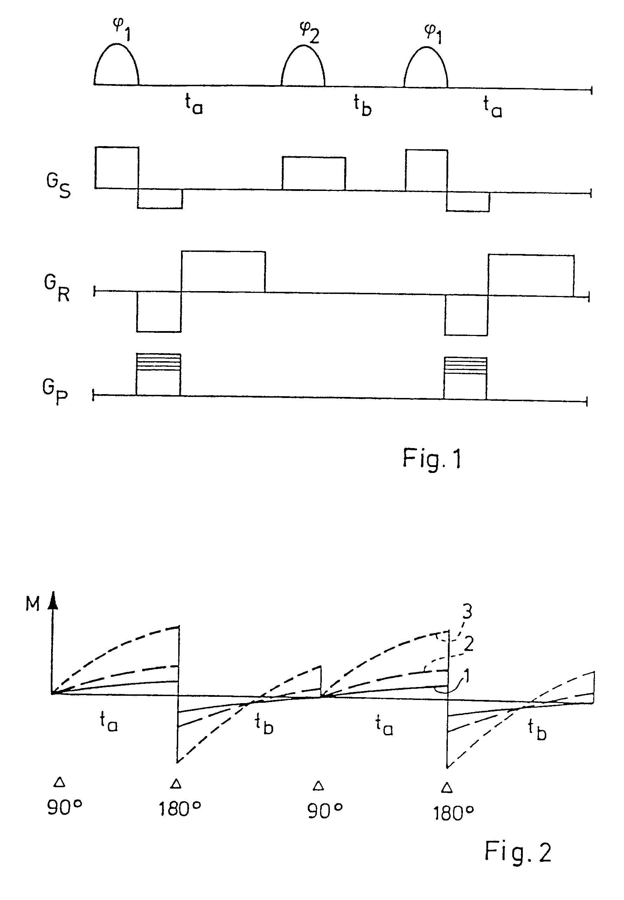

Bei der durch Fig. 1 veranschaulichten Anregungs-Sequenz erfolgt zunächst eine Anregung der Probe mittels eines HF-Anregungsimpulses $\varphi_1$ bei Anwesenheit eines Scheibengradienten $G_S$. Nach Ende des HF-Anregungsimpulses wird die unter dem Scheibengradienten erfolgte Dephasierung der Magnetisierungen durch Inversion des Scheibengradienten $G_S$ korrigiert. Während der Dauer des invertierten Scheibengradienten $G_S$ wird die Probe einem invertierten Lesegradienten $G_R$ ausgesetzt, dessen Umkehr nach Ende des Scheibengradienten $G_S$ zur Erzeugung eines Spin-Echo-Signales führt. Die zur Bilderzeugung notwendige Variation des unter dem Lesegradienten $G_R$ erhaltenen Echosignales wird durch Anwendung eines von Aufnahmezyklus zu Aufnahmezyklus variierenden Phasengradienten $G_P$ erzielt, der jeweils während der Zeit anliegt, während welcher der Scheibengradient $G_S$ und der Lesegradient $G_R$ invertiert sind. Anschließend wird nach einer Zeit $t_a$ das Spinensemble einem HF-Sättigungsimpuls $\varphi_2$ ausgesetzt, während dessen Dauer die Probe ebenfalls einem Scheibengradienten $G_S$ ausgesetzt ist, der allerdings nicht mit dem während des HF-Anregungsimpulses $\varphi_1$ herrschenden Scheibengradienten übereinzustimmen braucht. Nach einer weiteren Wartezeit $t_b$, während der ein Gradient angelegt wird, um die durch den HF-Sättigungsimpuls $\varphi_2$ erzeugte Kohärenz der transversalen Magnetisierung zu zerstören, wird die Sequenz wiederholt. Bei diesem Gradienten kann es sich in einfacher Weise um den Scheibengradienten für den HF-Sättigungsimpuls $\varphi_2$ handeln. Nach wenigen Wiederholungen dieser Sequenz erreicht das System einen stationären Zustand, bei dem die Magnetisierung in dem angeregten Bereich einen minimalen Wert hat.

Bei einmaliger Anregung gilt für die seitliche Entwicklung einer z-Magnetisierung M, die zum Zeitpunkt t=0 den Wert $M_a$ hat und deren Gleichgewichtswert gleich $M_O$ ist,

$$M = M_a \exp(-t/T_1) + M_O [1 - \exp(-t/T_1)] \quad (1)$$

Außerdem gilt für die Drehung der z-Magnetisierung $M_a$ durch einen HF-Impuls um den Flipwinkel $\psi$

$$M_p = M_a \cdot \cos \psi \quad (2)$$

Wird die anhand Fig. 1 erläuterte Sequenz mehrfach hintereinander angewendet, so erhält man für die Magnetisierung $M_{SS}$ im stationären Zustand unmittelbar vor dem HF-Anregungsimpuls $\varphi_1$ den Wert

$$M_{SS} = \frac{M_O [1 - \exp(-t_a/T_1)] \cdot \cos\beta \cdot \exp(-t_b/T_1) + M_O[1-\exp(-t_b/T_1)]}{1 - \cos\alpha \cos\beta \exp[-(t_a + t_b)/T_1]} \quad (3)$$

In dieser Gleichung ist $\alpha$ der Flipwinkel des HF-Anregungsimpulses $\varphi_1$ und $\beta$ der Flipwinkel des HF-Sättigungsimpulses $\varphi_2$.

Eine maximale Signalunterdrückung ist dann erreicht, wenn $M_{SS}$ möglichst klein ist. Im nachfolgenden werden einige Spezialfälle untersucht, unter denen $M_{SS}$ einen kleinen Wert annimmt, die Restmagnetisierung also, wie angestrebt, nur noch klein ist.

Werden der HF-Anregungsimpuls $\varphi_1$ und der HF-Sättigungsimpuls $\varphi_2$ so gewählt, daß ihre Flipwinkel $\alpha = 90°$ bzw. $\beta = 180°$, so werden $\cos\alpha = 0$ und $\cos\beta = -1$. Setzt man diese Werte in Gl. (3) ein, so erhält man

$$M_{SS} = M_0 \left\{ 1 - 2\exp(-t_b/T_1) + \exp\left[-(t_a + t_b)/T_1\right] \right\} \qquad (4)$$

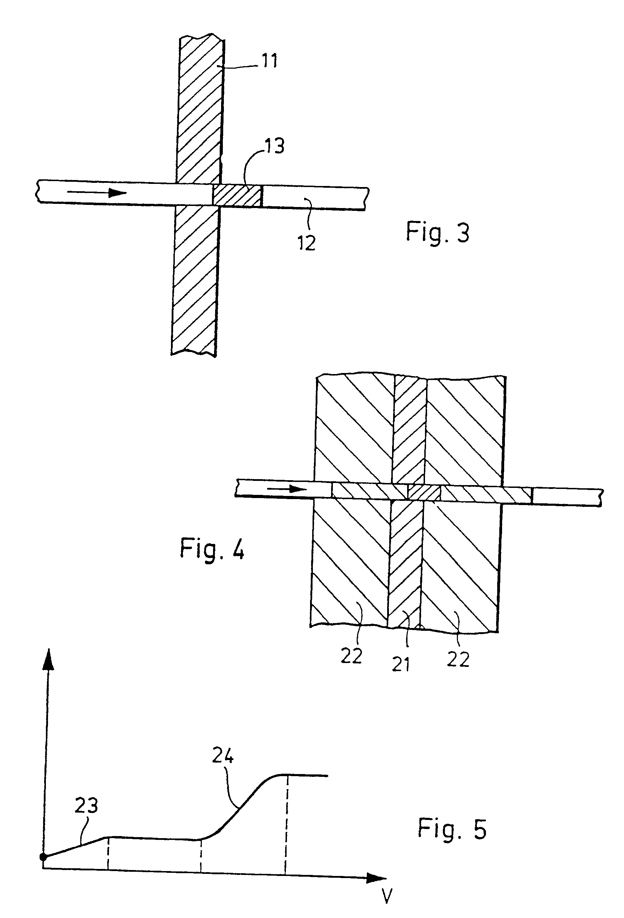

Für ein Material mit langer Spin-Gitter-Relaxationszeit $T_1$ wird in erster Näherung $M_{SS} = 0$ wenn $t_a = t_b$. Der Verlauf der Magnetisierung für große Relaxationszeiten $T_1$ ist in Fig. 3 durch die Kurve 1 wiedergegeben. Für mittlere und kurze Relaxationszeiten $T_1$ ist $M_{SS}$ von 0 noch erheblich verschieden, wie es die Kurven 2 und 3 zeigen.

Menschliches Körpergewebe hat Bereiche mit sehr unterschiedlichen Relaxationszeiten $T_1$. Daher ist es in diesem Falle nicht immer am vorteilhaftesten, zur Unterdrückung der z-Magnetisierung $t_a$ und $t_b$ gleich zu machen, d.h. den HF-Selektionsimpuls $\varphi_2$ genau in die Mitte zwischen zwei aufeinanderfolgende HF-Anregungsimpulse $\varphi_1$ zu legen. Vielmehr ist es dann zweckmäßig, $t_a$ und $t_b$ auf ein minimales stationäres Signal einzustellen.

Eine andere Möglichkeit besteht darin, die Magnetisierung im stationären Zustand durch Justieren der Flipwinkel bei vorgegebenen Impulsabständen $t_a$ und $t_b$ einzustellen. Wird beispielsweise der Flipwinkel $\alpha$ des HF-Anregungsimpulses $\varphi_1$ auf 90° eingestellt, so läßt sich der Flipwinkel $\beta$ des HF-Sättigungsimpulses berechnen, für den $M_{SS} = 0$ wird. Aus Gl. (3) folgt

$$\cos\beta = \frac{\exp(-t_b/T_1) - 1}{\left[1 - \exp(t_a/T_1)\right]\exp(-t_b/T_1)} \qquad (5)$$

Auch hier hängt der Flipwinkel $\beta$ für völlige Signalauslöschung von der Relaxationszeit $T_1$ ab, die jedoch nicht für die gesamte Probe einheitlich ist, so daß durch Probieren der Wert von $\beta$ gefunden werden muß, bei dem bei vorgegebenem $t_a$ und $t_b$ eine maximale Signalunterdrückung erreicht wird.

Bisher wurde davon ausgegangen, daß in der Sequenz nach Fig. 1 die HF-Anregungsimpulse und HF-Sättigungsimpulse in Verbindung mit den zugehörigen Scheibengradienten so gewählt werden, daß von beiden genau die gleiche Scheibe des Körpers erfaßt wird. Die beschriebene Justierung von $t_a$ und $t_b$ bzw. $\beta$ hat dann zur Folge, daß das im Bereich der angeregten Querschnittsebene vorhandene stationäre Material nur einen sehr unbedeutenden Signalanteil liefert. Fig. 3 zeigt den Zustand, bei dem die Scheibe 11 in der beschriebenen Weise so angeregt worden ist, daß die Magnetisierung ein Minimum hat und daher das stationäre Material nahezu kein Signal liefert. Die Scheibe 11 wird von einem Gefäß 12 durchsetzt, in dem sich eine strömende Flüssigkeit, beispielsweise Blut, befindet. Das Volumenelement 13, das sich zunächst im Bereich der Scheibe 11 befand, wird durch die Strömung im Gefäß 12 aus dem Bereich der Scheibe 11 hinausgetragen und durch Flüssigkeit ersetzt, die dem Sättigungsvorgang nicht ausgesetzt worden war. Daher liefert diese Flüssigkeit ein kräftiges Signal, so daß das Gefäß 12 in einem die Scheibe 11 des Körpers wiedergebenden Querschnittsbild mit großer Deutlichkeit zu erkennen ist.

Durch entsprechende Wahl der Frequenz des HF-Sättigungsimpulses $\varphi_2$ und der Stärke des Scheibengradienten $G_S$ ist es möglich, die von dem HF-Anregungsimpuls und von dem HF-Selektionsimpuls erfaßten Bereiche unterschiedlich zu gestalten. Bei dem in Fig. 4 veranschaulichten Fall werden durch den HF-Anregungsimpuls $\varphi_1$ die Spins im Bereich einer sehr dünnen Scheibe 21 angeregt, während der HF-Selektionsimpuls $\varphi_2$ im Bereich einer sehr viel dickeren Scheibe 22 wirkt. Die von dem Anregungsimpuls angeregte Scheibe 21 ist zentral zur dickeren Scheibe 22 angeordnet. Die zur Bilddarstellung verwendeten Resonanzsignale stammen immer aus der mittels der HF-Anregungsimpulse $\varphi_1$ angeregten Scheibe 21.

Für einen stationären Zustand der Magnetisierung erhält man in diesem Fall

$$M_{SS} = M_0 [1-\exp(-(t_a + t_b)/T_1)] / [1-\cos\beta \exp(-(t_a + t_b)/T_1] \qquad (6)$$

In diesem Fall wird die Magnetisierung $M_{SS}$ im stationären Zustand gegenüber dem Gleichgewichtswert $M_O$ der Magnetisierung sehr klein, d.h. die Magnetisierung im stationären Zustand geht gegen O, wenn $t_a + t_b$ klein ist gegen $T_1$. In diesem Fall wird dann nicht nur das stationäre Gewebe in der Region 21 signalgeschwächt dargestellt, sondern auch sämtliches Material, welches sich in der dickeren Scheibe 22 befindet. Damit ist auch das der zentralen Scheibe 21 zufließende Material zunächst signalgeschwächt, bis das aus der außerhalb der Scheibe 22 gelegene Material die zentrale Scheibe 21 erreicht. Hierdurch wird unter Variation der Dicke der Scheibe 22 eine quantitative Bestimmung der Fließgeschwindigkeit möglich. Fig. 5 veranschaulicht, wie zunächst die Signalstärke ansteigt, wenn Material aus der Scheibe 22 in den Bereich der Scheibe 21 gelangt (Kurvenabschnitt 23). Das etwas stärkere Signal bleibt dann so lange erhalten, wie sich Material aus der Scheibe 22 im Bereich der Scheibe 21 befindet. Erreicht dann das von außerhalb der Scheibe 22 stammende Material die Scheibe 21, findet im Bereich 24 der Kurve nach Fig. 5 ein sehr starker Signalanstieg statt, bis das Signal konstant bleibt, wenn sich nur noch von außerhalb der Scheibe 22 stammendes Material im Bereich der Scheibe 21 befindet.

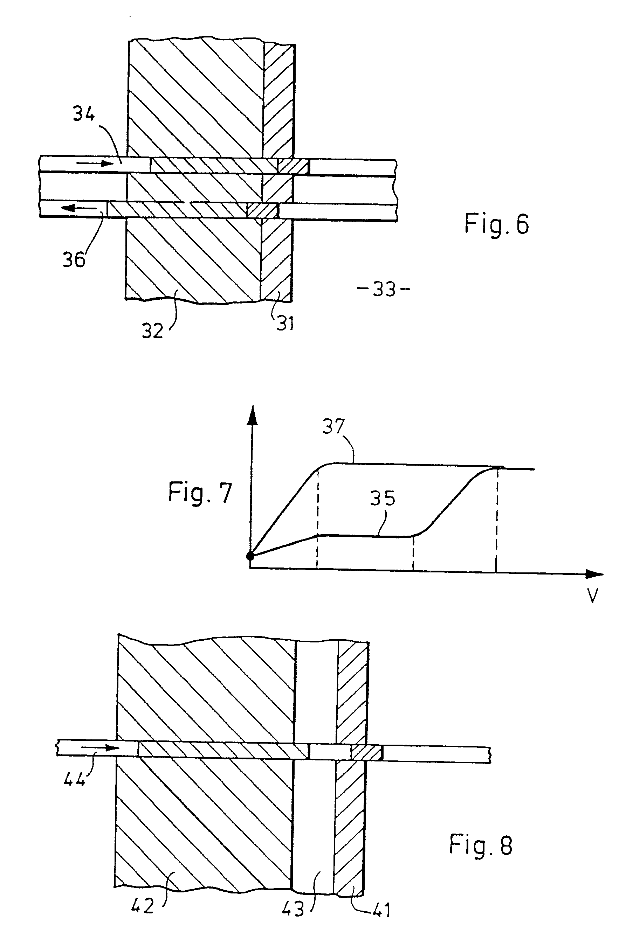

Fig. 6 veranschaulicht eine Variante, bei der das mittels des HF-Sättigungsimpulses $\varphi_2$ erfaßte Volumen 32 zu dem von dem HF-Anregungsimpuls $\varphi_1$ erfaßten Volumen 31 nicht konzentrisch angeordnet ist, sondern in der Weise, daß sich die beiden Volumina zwar decken, das Volumen 32 jedoch über das Volumen 31 nur einseitig übersteht. Auf diese Weise entstehen stark unterschiedliche Signale in Abhängigkeit davon, ob der Scheibe 31 neues Material aus dem überhaupt nicht angeregten Bereich 33 oder aber aus der dickeren Scheibe 32 zufließt. Für den aus der Scheibe 32 zufließenden Anteil im oberen Gefäß 34 ergibt sich ein Signalverlauf, der dem Signalverlauf nach Fig. 5 gleicht und der in Fig. 7 durch die Kurve 35 wiedergegeben ist. Dagegen findet für Volumina, die aus der anregungafreien Zone 33 in die Scheibe 31 einströmen, wie es bei dem in Fig. 6 unteren Gefäß 36 der Fall ist, ein sofortiger steiler Signalanstieg statt, wie es die Kurve 37 in Fig. 7 wiedergibt.

Endlich sei auch noch der Fall betrachtet, daß die beiden mittels der HF-Anregungsimpulse $\varphi_1$ und der mittels der HF-Sättigungsimpulse $\varphi_2$ angeregten Bereiche 41, 42 gänzlich voneinander getrennt sind, sich zwischen ihnen also eine nicht angeregte Scheibe 43 befindet, wie es in Fig. 8 dargestellt ist.

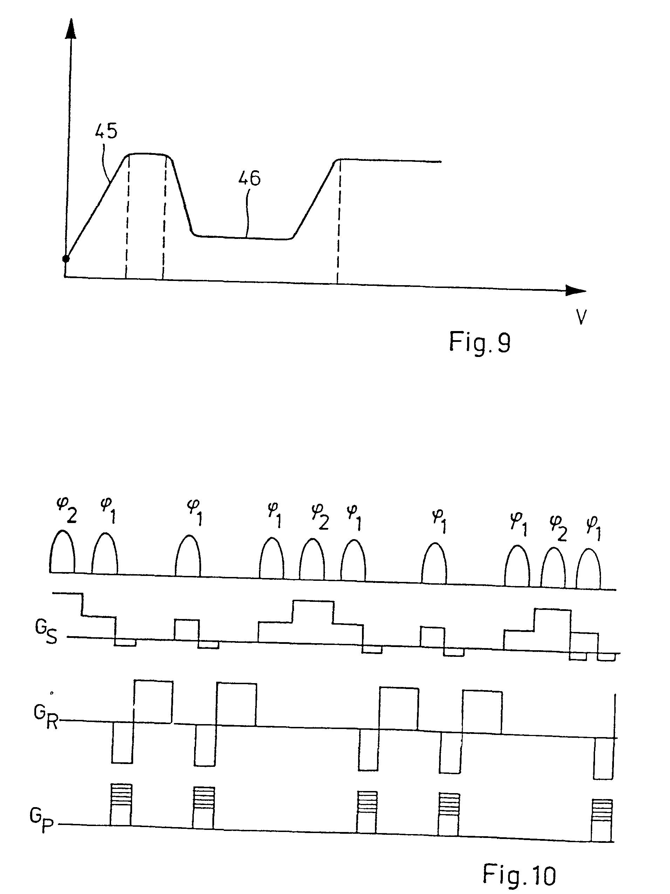

Der Signalverlauf wird wiederum durch die in Fig. 9 dargestellte Kurve wiedergegeben. Der Signalanstieg 45 entspricht dem Einfließen von Material aus der nicht angeregten Scheibe 43 in den Bereich der angeregten Scheibe 41. Danach erreicht das Material aus der weniger stark angeregten Scheibe 42 die Scheibe 41, wodurch es zu dem durch den trapezförmigen Kurvenabschnitt 46 wiedergegebenen Signalabfall mit anschließendem Signalanstieg kommt, der beginnt, wenn wiederum noch nicht angeregtes Material von jenseits der Scheibe 42 die Scheibe 41 erreicht.

Fig. 10 zeigt noch eine Variante einer Anregungs-Sequenz, bei der ein HF-Sättigungsimpuls $\varphi_2$ nicht zwischen allen aufeinanderfolgenden HF-Anregungsimpulsen $\varphi_1$ vorgesehen ist, sondern nur nach jedem jeweils dritten HF-Anregungsimpuls $\varphi_1$. Diese HF-Anregungsimpulse $\varphi_1$ folgen im übrigen so dicht aufeinander, daß sie jeweils unmittelbar an die dem vorhergehenden HF-Anregungsimpuls folgende Lesephase anschließen. Infolgedessen muß diese Lesephase entfallen, wenn ein HF-Sättigungsimpuls $\varphi_2$ eingeschaltet wird, wie es Fig. 10 zeigt. Auch hier können wieder die HF-Impulse $\varphi_1$ und $\varphi_2$ unterschiedliche Trägerfrequenzen haben, so daß sie in Verbindung mit Scheibengradienten $G_S$ unterschiedlicher Höhe und Steilheit Scheiben unterschiedlicher Lage und Dicke anregen können.

Endlich sei noch erwähnt, daß sich nach dem erfindungsgemäßen Verfahren durchgeführte Messungen von fließenden Substanzen in der Medizin leicht mit einer Beobachtung des Herzschlages Koppeln lassen, indem die NMR-Messungen von einem aufgenommenen EKG aus synchronisiert werden. Vom EKG eines Patienten können Torsignale abgeleitet werden, die es ermöglichen, eine Anzahl von Echosignalen mit gleicher Phasenkodierung auszulesen. Bei der nächsten Triggerung kann wieder eine Anzahl untereinander gleichartig, jedoch anders als zuvor kodierter Signale ausgelesen werden, wie es zur Erzeugung von EKG-synchronen Flußbildern erforderlich ist.

## Ansprüche

1. Verfahren zum Bestimmen fließenden Materials innerhalb eines geschlossenen Körpers mittels NMR-Tomographie, bei dem der Körper ausgewählten Magnetfeldern ausgesetzt und die im Bereich einer durch einen Scheibengradienten definierten Querschnittsebene des Körpers vorhandenen Spins selektiv durch Sequenzen von Anregungsimpulsen angeregt werden, deren Abstand Kleiner ist als die Spin-Gitter-Relaxationszeit, so daß es im Verlauf der Aufnahmezeit zu einer wenigstens teilweisen Sättigung der Magnetisierung kommt, die ihrerseits eine Verminderung der Intensität der Resonanzsignale zur Folge hat, und bei dem die Resonanzsignale zur Erzeugung eines Bildes der Querschnittsebene des Körpers verarbeitet werden, in dem sich diejenigen Stellen, an denen der Querschnittsebene von außen zugeflossenes und daher weniger gesättigtes Material vorhanden ist, infolge der größeren Intensität der Resonanzsignale von der Umgebung durch eine größere Helligkeit abheben, dadurch gekennzeichnet, daß auf den Körper zwischen aufeinanderfolgenden HF-Anregungsimpulsen ($\varphi_1$) bei Anliegen eines weiteren Scheibengradienten ($G_S$) zusätzliche HF-Sättigungs-impulse ($\varphi_2$) eingestrahlt werden und durch Wahl des zeitlichen Abstandes ($t_a$, $t_b$) zwischen den HF-Anregungs-impulsen ($\varphi_1$) und den HF-Sättigungsimpulsen ($\varphi_2$) und/oder der durch diese Impulse bewirkten Flipwinkel ($\alpha$, $\beta$) ein stationärer Zustand mit minimaler Magnetisierung in wenigstens einem der durch die Scheibengradienten ($G_S$) bestimmten Bereich eingestellt ist.

2. Verfahren nach Anspruch 1, dadurch gekennzeichnet, daß die durch die HF-Anregungsimpulse ($\varphi_1$) und durch die HF-Sättigungsimpulse ($\varphi_2$) angeregten Bereiche (11) im wesentlichen identisch sind.

3. Verfahren nach Anspruch 1, dadurch gekennzeichnet, daß der durch die HF-Sättigungsimpulse ($\varphi_2$) angeregte Bereich (22) den durch die HF-Anregungsimpulse ($\varphi_1$) angeregten Bereich (21) einschließt.

4. Verfahren nach Anspruch 3, dadurch gekennzeichnet, daß ein Rand des durch die HF-Anregungsim-pulse ($\varphi_1$) angeregten Bereiches (31) mit einem Rand des durch die HF-Sättigungsimpulse ($\varphi_2$) angeregten Bereiches (32) zusammenfällt.

5. Verfahren nach einem der vorhergehenden Ansprüche, dadurch gekennzeichnet, daß der während der Dauer der HF-Anregungsimpulse ($\varphi_1$) eingeschaltete Scheibengradient ($G_S$) nach Ende jedes HF-Anregungsimpulses zur Rephasierung der angeregten Spins umgekehrt wird, daß nach jedem HF-Anregungsimpuls ($\varphi_1$) ein Lesegradient ($G_R$) und ggf. ein Phasengradient ($G_p$) für die Dauer der Umkehrung des Scheibengradienten ($G_S$) eingeschaltet werden, daß danach der Lesegradient ($G_R$) zur Erzeugung eines Spin-Echo-Signales umgekehrt wird und daß ein HF-Sättigungsimpuls ($\varphi_2$) jeweils zwischen zwei aufeinanderfolgenden HF-Anregungs-impulsen ($\varphi_1$) eingestrahlt wird.

6. Verfahren nach einem der vorhergehenden Ansprüche, dadurch gekennzeichnet, daß zur Messung des Blutstromes im menschlichen Körper die einzelnen Verfahrensschritte von einem Elektrokardiographen synchron ausgelöst werden.

## Claims

1. Method for the identification of flowing matter within a closed body by means of NMR-tomography, in which the body is exposed to selected magnetic fields and the spins present in the region of a cross-sectional plane of the body defined by a slice gradient is smaller than the spinlattice relaxation time, so that during the recording time there is an at least partial saturation of the magnetization, which leads to a reduction in the intensity of the resonance signals and in which the resonance signals are processed to produce an image of the cross-sectional plane of the body, in which those points where matter is present which has flowed into the cross-sectional plane from the outside and is therefore less saturated is emphasized compared with the surrounding area by a greater brightness due to the greater intensity of the resonance signals, characterized in that additional r.f. saturation pulses ($\varphi_2$) are applied to the body in the presence of a further slice gradient ($G_S$) bet-ween succeeding r.f. excitation pulses ($\varphi_1$) and by the choice of the time interval ($t_a$, $t_b$) between the r.f. excitation pulses ($\varphi_1$) and the r.f. saturation pulses ($\varphi_2$) and/or the flip angle ($\alpha$, $\beta$) brought about by these pulses, a minimum magnetization stationary state is obtained in at least one area defined by the slice gradient ($G_S$).

2. Method according to Claim 1, characterized in that the areas (11) excited by the r.f. excitation pulses ($\varphi_1$) and by the r.f. saturation pulses ($\varphi_2$) are substantially identical.

3. Method according to Claim 1, characterized in that the area (22) excited by the r.f. saturation pulses ($\varphi_2$) includes the area (21) excited by the r.f. excitation pulses ($\varphi_1$).

4. Method according to Claim 3, characterized in that one edge of the area (31) excited by the r.f. excitation pulses ($\varphi_1$) coincides with one edge of the area (32) excited by the r.f. saturation pulses ($\varphi_2$).

5. Method according to one of the preceding claims, characterized in that the slice gradient ($G_S$) activated for the duration of the r.f. excitation pulses ($\varphi_1$) is reversed at the end of each r.f. excitation pulse for rephasing the excited spins, that following each r.f. excitation pulse ($\varphi_1$) a reading gradient ($G_R$) and optionally a phase gradient ($G_p$) are activated for the duration of the reversal of the slice gradient ($G_S$), that subsequently the read-ing gradient ($G_R$) is reversed for generating a spin echo signal and that in each case an r.f. saturation pulse ($\varphi_2$) is irradiated between two successive r.f. excitation pulses ($\varphi_1$).

6. Method according to one of the preceding claims, characterized in that the individual method steps are synchronously triggered by an electrocardiograph for measuring the blood flow in the human body.

## Revendications

1. Procédé pour déterminer une substance en écoulement à l'intérieur d'un corps fermé, au moyen de la tomographie RMN, et selon lequel on soumet le corps à des champs magnétiques sélectionnés et on excite de façon sélective les spins présents dans la région d'un plan de coupe transversale du corps, définie par un gradient d'obtention d'une tranche du corps, au moyen de séquence d'impulsions d'excitation, dont l'intervalle de séparation est inférieur au temps de relaxation spin-réseau, de sorte que pendant la durée d'enregistrement, il se produit une saturation au moins partielle de l'aimantation, qui, pour sa part, entraîne une réduction de l'intensité des signaux de résonance, et selon lequel on traite les signaux de résonance de manière à obtenir une image du plan de coupe transversal du corps, dans laquelle les emplacements, au niveau desquels est présente une substance pénétrant depuis l'extérieur dans le plan de coupe transversal et par conséquent moins saturée, sont mis en évidence par rapport à l'environnement au moyen d'une luminosité accrue, en raison de l'intensité supérieure des signaux de résonance,
caractérisé par le fait
qu'en d'un autre champ de gradient $(G_S)$ d'obtention d'une tranche du corps, des impulsions supplémentaires de saturation HF $(\varphi_2)$ sont envoyées au corps entre des impulsions d'excitation HF successives $(\varphi_1)$ et que, grâce au choix de l'intervalle de temps $(t_a, t_b)$ entre les impulsions d'excitation HF $(\varphi_1)$ et les impulsions de saturation HF $(\varphi_2)$ et/ou grâce au choix des angles de pivotement $(\alpha, \beta)$ provoqués par ces impulsions, un état stationnaire possédant une aimantation minimale s'établit au moins dans une région déterminée par les gradients $(G_S)$ d'obtention d'une tranche du corps.

2. Procédé suivant la revendication 1, caractérisé par le fait que les régions (11) excitées par les impulsions d'excitation HF $(\varphi_1)$ et par les impulsions de saturation $(\varphi_2)$ sont sensiblement identiques.

3. Procédé suivant la revendication 1, caractérisé par le fait que la région (22) excitée par les impulsions de saturation HF $(\varphi_2)$ enserre la région (21) excitée par les impulsions d'excitation $(\varphi_1)$.

4. Procédé suivant la revendication 3, caractérisé par le fait qu'un bord de la région (31) excitée par les impulsions d'excitation HF $(\varphi_1)$ coïncide avec un bord de la région (32) excitée par les impulsions de saturation HF $(\varphi_2)$.

5. Procédé suivant l'une des revendications précédentes, caractérisé par le fait que le gradient $(G_S)$ d'obtention d'une tranche du corps, activé pendant la durée des impulsions d'excitation HF $(\varphi_1)$, est inversé à la fin de chaque impulsion d'excitation HF de manière à remettre en phase les spins excités, qu'après chaque impulsion d'excitation HF $(\varphi_1)$, on applique un gradient de lecture $(G_R)$ et éventuellement un gradient de phase $(G_P)$ pendant la durée de l'inversion du gradient $(G_S)$ d'obtention d'une tranche du corps qu'en suite le gradient de lecture $(G_R)$ est inversé pour la production d'un signal de spin-écho, et qu'on envoie une impulsion de saturation HF $(\varphi_2)$ respectivement entre deux impulsions successives d'excitation HF $(\varphi_1)$.

6. Procédé suivant l'une des revendications précédentes, caractérisé par le fait que pour la mesure de l'écoulement du sang dans le corps humain, les différentes étapes opératoires sont déclenchées en synchronisme par un électrocardiographe.

Fig. 1

Fig. 2

Fig. 3

11

13

12

Fig. 4

22  21  22

Fig. 5

24

23

V

Fig. 6

34

36

32       31

-33-

Fig. 7

37

35

V

Fig. 8

44

42       43    41

45

46

V

Fig.9

$\varphi_2$ $\varphi_1$ $\varphi_1$ $\varphi_1$ $\varphi_2$ $\varphi_1$ $\varphi_1$ $\varphi_1$ $\varphi_2$ $\varphi_1$

$G_S$

$G_R$

$G_P$

Fig.10